# EUROPÄISCHE PATENTSCHRIFT

(11) **EP 0 601 217 B1**
(45) Veröffentlichungstag und Bekanntmachung des Hinweises auf die Patenterteilung: **26.07.1995**
(21) Anmeldenummer: 92120165.3
(22) Anmeldetag: 26.11.1992
(51) Int. Cl.: H03B 25/00, H03B 5/36

(54) **Oszillatorschaltung**
Oscillator circuit
Circuit oscillateur

(43) Veröffentlichungstag der Anmeldung: 15.06.1994
(73) Patentinhaber: HAGENUK GMBH, D-24118 Kiel (DE)
(72) Erfinder: Wiesenthal, Hartmut, W-2307 Schwedeneck 1 (DE); Behrent, Hermann, W-2071 Kuddewörde (DE)
(74) Vertreter: Hansmann, Dierk, Dipl.-Ing.

(56) Entgegenhaltungen:
- EP-A- 0 400 425
- US-A- 4 859 969
- 43 ANNUAL SYMP. ON FREQUENCY CONTROL 31. Mai 1989, DENVER Seiten 2 - 7 , XP000089394 SCHODOWSKI 'RESONATOR SELF-TEMPERATURE-SENSING USING A DUAL-HARMONIC-MODE CRYSTAL OSCILLATOR'

## Beschreibung

Die Erfindung betrifft eine Vorrichtung zur gleichzeitigen Erzeugung von zwei elektrischen Schwingungen mit unterschiedlichen Frequenzen, die einen Schwingquarz mit mindestens zwei unterschiedlichen Resonanzfrequenzen aufweist.

Derartige Vorrichtungen können beispielsweise eingesetzt werden, um im Bereich von Kommunikationsgeräten hochgenaue Referenzfrequenzen bereitzustellen. Diese werden benötigt, um frequenzvariable Oszillatoren exakt führen zu können. Durch die Verwendung des Schwingquarzes kann innerhalb eines Arbeitstemperaturbereiches eine vergleichsweise hohe Frequenzgenauigkeit gewährleistet werden. Bei sehr hohen Anforderungen an die Frequenzgenauigkeit beim Auftreten von Temperaturschwankungen ist es auch möglich, eine zusätzliche Temperaturkompensation mit Hilfe von Temperaturfühlern und nachgeschalteten Stellgliedern durchzuführen. In der Regel sind der Temperaturfühler und der als Referenz dienende Schwingquarz räumlich voneinander getrennt angeordnet. Hieraus resultiert ein unterschiedliches Übertragungsverhalten bei sich ändernden Temperaturen, das eine dynamische und hystereseförmige Frequenzablage zur Folge hat.

Zur Eichung bzw. zur Kalibrierung eines temperaturkompensierten Quarzoszillators wird ermittelt, um welchen Wert sich die Resonanzfrequenz des Schwingquarzes in Abhängigkeit von der sich ändernden Temperatur von einem Frequenznormal entfernt. Dieser Vorgang erfordert einen erheblichen Zeitaufwand, da bei jedem Wechsel der Temperatur ein ausreichender Zeitraum erforderlich ist, um sowohl im Bereich des Temperaturfühlers als auch im Bereich des Schwingquarzes ein annähernd gleiches Temperaturniveau zu gewährleisten. Dieses gleiche Temperaturniveau ist erforderlich, um Hystereseeffekte zu vermeiden.

Zusätzlich zur Erzeugung der beiden Frequenzen mit Hilfe des Quarzoszillators, die von Herzog in dem im Springer-Verlag erschienenen Buch "Quarzoszillatoren" beschrieben ist, wird deshalb im Tagungsband des IEEE "43rd Annual Symposium on Frequency Control - 1989" Seiten 2 bis 7, vorgeschlagen, den Schwingquarz selbst zur Temperaturermittlung zu verwenden. Der Schwingquarz wird dabei gleichzeitig bezüglich zweier seiner Resonanzfrequenzen angeregt. Durch die Auswertung dieser zwei Frequenzen ist es möglich, eine Temperaturmessung unmittelbar im Bereich des Schwingquarzes durchzuführen und dadurch Hystereseeffekte, bzw. den für einen Temperaturausgleich erforderlichen Zeitaufwand, zu vermeiden.

Aufgabe der vorliegenden Erfindung ist es, eine Vorrichtung der einleitend genannten Art derart zu konstruieren, daß eine einfache und zuverlässige Schaltung zur Erzeugung der elektrischen Schwingungen mit unterschiedlicher Frequenzen bereitgestellt wird.

Diese Aufgabe wird bei einer Vorrichtung nach dem Oberbegriff des Anspruchs 1 erfindungsgemäß dadurch gelöst, daß ein Emitter eines ersten Transistors über den Schwingquarz mit einem Emitter eines zweiten Transistors verbunden ist, die Basen der Transistoren jeweils über Basisschwingkreise mit einem unteren Bezugspotential und die Kollektoren der Transistoren jeweils über Kollektorschwingkreise mit einem oberen Bezugspotential verbunden sind, die Basis jeweils eines der Transistoren elektrisch mit dem Kollektor jeweils des anderen Transistors verbunden ist und die Basen der Transistoren jeweils über Wechselstromkoppler an das untere Bezugspotential angeschlossen sind.

Durch die erfindungsgemäße Schaltung des Schwingquarzes wird eine erste elektrische Schwingung über den als Basis-Basis-Stufe geschalteten ersten Transistor angefacht und über den zweiten Transistor als Emitterfolger zurückgekoppelt. In einer entgegengesetzten Signalflußrichtung wird gleichzeitig eine zweite Schwingung mit einer anderen Frequenz durch den zweiten Transistor angefacht, der gleichfalls als Basis-Basis-Stufe geschaltet ist. Hier erfolgt eine Rückkopplung über den als Emitterfolger geschalteten ersten Transistor. Die Frequenzen werden jeweils durch die Dimensionierung der Schwingkreise festgelegt.

Zur Gewährleistung einer Anregung des Schwingquarzes mit seinen Resonanzfrequenzen entsprechenden Anregungsfrequenzen wird vorgeschlagen, daß eine Übertragungsfunktion des einen Kollektorschwingkreises eine Nullstelle für die erste zu erzeugende Frequenz und eine Übertragungsfunktion des anderen Kollektorschwingkreises eine Nullstelle für die zweite zu erzeugende Frequenz aufweist.

Zur Gewährleistung einer ausreichenden Frequenzselektivität ist darüber hinaus vorgesehen, daß eine Übertragungsfunktion des einen Kollektorschwingkreises eine Polstelle für die zweite zu erzeugende Frequenz und eine Übertragungsfunktion des anderen Kollektorschwingkreises eine Polstelle für die erste zu erzeugende Frequenz aufweist.

Eine besonders einfache Ausbildung der Kollektorschwingkreise kann dadurch realisiert werden, daß der eine Kollektorschwingkreis aus einer Parallelschaltung eines Kondensators und einer Induktivität und der andere Kollektorschwingkreis gleichfalls aus einer Parallelschaltung eines Kondensators und einer Induktivität ausgebildet ist.

Eine funktionelle Gestaltung der Basisschwingkreise wird dadurch bereitgestellt, daß sowohl der eine Basisschwingkreis aus einer Reihenschaltung eines Kondensators und einer Induktivität als auch der andere Basisschwingkreis aus einer Reihenschaltung eines Kondensators und einer Induktivität ausgebildet ist.

Zur Gewährleistung einer Abstimmung der Resonanzfrequenzen der Kollektorschwingkreise und der Basisschwingkreise ist vorgesehen, daß jeweils der eine Kollektorschwingkreis und der zugeordnete Basisschwingkreis, bzw. der andere Kollektorschwingkreis und der zugeordnete Basisschwingkreis, jeweils gleiche Resonanzfrequenzen aufweisen.

Eine Auskopplung der erzeugten elektrischen Schwingungen ohne wesentliche Rückwirkungen auf das Schwingverhalten kann dadurch ermöglicht werden, daß die Basis mindestens eines der Transistoren mit der Basis eines Ausgangstransistors verbunden ist, dessen Kollektor an das obere Bezugspotential und dessen Emitter über einen Widerstand an das untere Bezugspotential angeschlossen ist.

Eine potentialfreie Rückkopplung kann dadurch erfolgen, daß mindestens einer der Kondensatoren aus einer Reihenschaltung von Kondensatoren ausgebildet ist und die Basis des jeweils zugeordneten Transistors mit dem Mittelabgriff der Kondensatoren verbunden ist.

Ein zweckmäßiger Einsatz der Vorrichtung kann dadurch erfolgen, daß der Schwingquarz als ein Temperaturfühler zur Durchführung eines Frequenzabgleiches einer ihn beinhaltenden Oszillatorschaltung ausgebildet ist.

In der Zeichnung sind Ausführungsbeispiele der Erfindung schematisch dargestellt. Es zeigen:
- Fig. 1: eine teilweise Darstellung der Vorrichtung im Bereich einer vereinfachten Beschaltung des ersten Transistors,
- Fig. 2: eine teilweise Darstellung einer vereinfachten Beschaltung der Kombination des ersten mit dem zweiten Transistor,
- Fig. 3: eine weitere Darstellung einer vereinfachten Beschaltung mit einem Parallel- sowie einem Serienschwingkreis,
- Fig. 4: eine vereinfachte Schaltungsdarstellung mit einer Beschaltung des zweiten Transistors entsprechend der in Figur 3 dargestellten Beschaltung des ersten Transistors,
- Fig. 5: eine vollständige Darstellung der Beschaltung der Transistoren,
- Fig. 6: ein Schaltbild einer Variante der Vorrichtung, bei der zur Auskopplung der elektrischen Schwingungen zusätzlich eine Reihenschaltung jeweils eines Transistors mit jeweils einem Widerstand vorgesehen ist,
- Fig. 7: eine weitere Variante der Schaltung in einer teilweisen Darstellung, bei der die Kondensatoren der Parallelschwingkreise in jeweils einer Reihenschaltung von Kondensatoren aufgeteilt sind,
- Fig. 8: eine vereinfachte Darstellung der Vorrichtung,
- Fig. 9: eine Darstellung zur Lokalisierung von Polen und Nullstellen der mit den Schwingkreisen realisierten Übertragungsfunktionen **und**
- Fig. 10: eine weitere vereinfachte teilweise Darstellung der Vorrichtung zur Ermöglichung einer Zuordnung zu den Diagrammen in Figur 9.

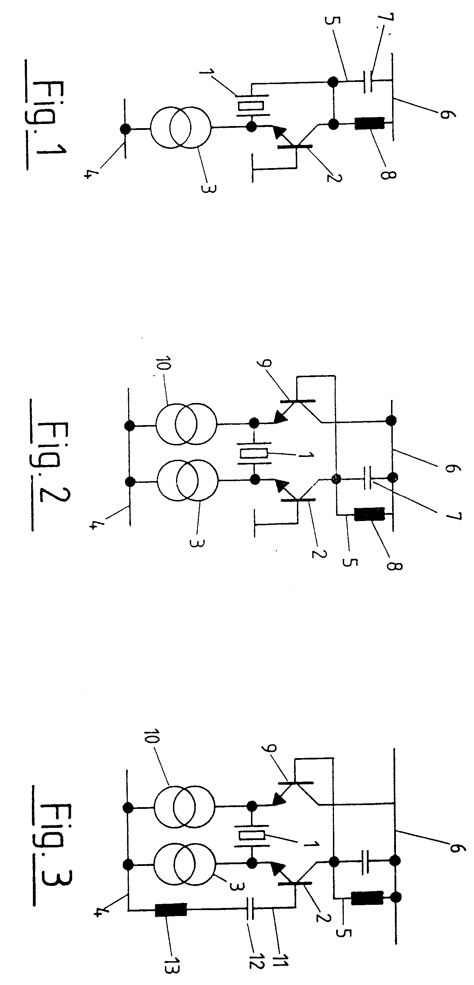

Zur Erläuterung der Vorrichtung zur gleichzeitigen Erzeugung von zwei elektrischen Schwingungen mit unterschiedlichen Frequenzen soll zunächst entsprechend der Darstellung in Figur 1 eine vereinfachte Schaltung beschrieben werden, die lediglich zur Generierung einer einzelnen Frequenz geeignet ist. Ein Schwingquarz (1) ist hierbei mit dem Emitter eines ersten Transistors (2) verbunden. Der Emitter ist darüber hinaus über einen Wechselstromkoppler (3), beispielsweise einen Spannungswandler, mit einem unteren Bezugspotential (4) verbunden. Ein Kollektor des ersten Transistors (2) ist über einen Kollektorschwingkreis (5) an ein oberes Bezugspotential (6) angeschlossen. Der Schwingquarz (1) ist im Bereich seines dem Emitter abgewandten Anschlusses mit dem Kollektor des ersten Transistors (2) verbunden. Der Kollektorschwingkreis (5) besteht aus einer Parallelschaltung eines Kondensators (7) und einer Induktivität (8). Durch den Kollektorschwingkreis (5) erfolgt eine frequenzselektive Rückkopplung vom Kollektor auf die Basis über den Schwingquarz (1). Der Kollektorschwingkreis (5) wird derart dimensioniert, daß seine Resonanzfrequenz an eine Resonanzfrequenz des Schwingquarzes (1) angepaßt ist.

Zur weiteren Verdeutlichung des Schaltprinzips ist in Figur 2 die Schaltung gemäß Figur 1 um einen zweiten Transistor (9) sowie einen weiteren Wechselstromkoppler (10) ergänzt. Der dem Emitter des ersten Transistors (2) abgewandte Anschluß des Schwingquarzes (1) ist hierbei an den Emitter des zweiten Transistors (9) angeschlossen. Die Basis des zweiten Transistors (9) ist mit dem Kollektor des ersten Transistors (2) verbunden. Der Kollektor des zweiten Transistors (9) ist an das obere Bezugspotential (6) angeschlossen. Zwischen den Kollektor des zweiten Transistors (9) und das untere Bezugspotential ist der Wechselstromkoppler (10) geschaltet. Durch die Schaltung des zweiten Transistors (9) als Emitterfolger wird der niederohmig wirkende Schwingquarz (1) an den vergleichsweise hochohmigen Lastkreis der vom ersten Transistor (2) ausgebildeten Basis-Basis-Stufe angeschlossen.

Eine weitere Modifikation zur Realisierung der erfindungsgemäßen Schaltung ist in Figur 3 dargestellt. Die Basis des ersten Transistors (2) ist hierbei über einen Basisschwingkreis (11) an das untere Bezugspotential (4) angeschlossen. Der Basisschwingkreis (11) besteht aus einer Serienschaltung eines Kondensators (12) und einer Induktivität (13). Hierdurch wird im Bereich einer Übertragungsfunktion eine Nullstelle bezüglich der imaginären Frequenzachse realisiert. Die Resonanzfrequenz des Basisschwingkreises (11) wird entsprechend der Resonanzfrequenz des Kollektorschwingkreises (5) gewählt.

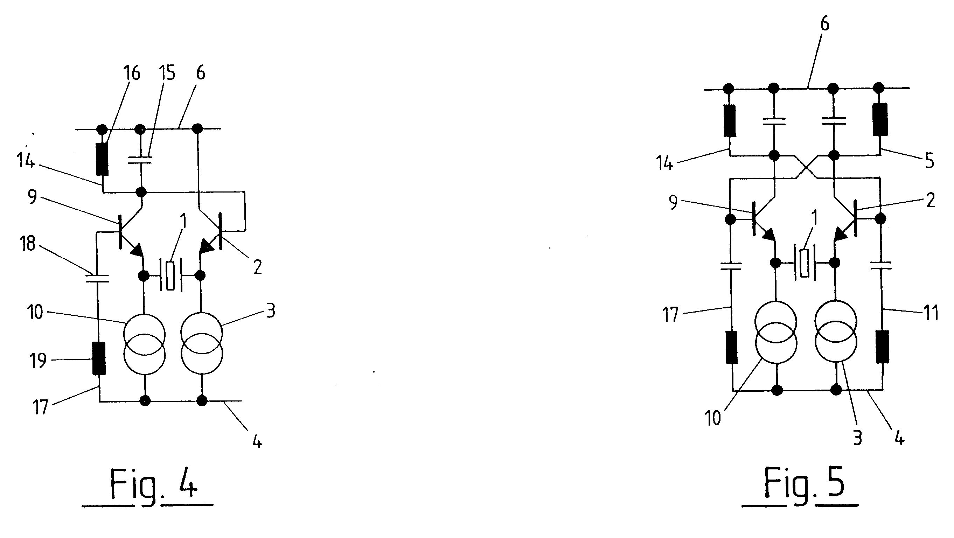

In Figur 4 ist eine Beschaltung des zweiten Transistors (9) dargestellt, die entsprechend der Beschaltung des ersten Transistors (2) gemäß der Darstellung in Figur 3 gewählt wurde. Auch hier besteht ein Kollektorschwingkreis (14) aus einem Kondensator (15) und einer Induktivität (16). Ein Basisschwingkreis (17) ist aus der Reihenschaltung eines Kondensators (18) und einer Induktivität (19) ausgebildet. Der Kollektorschwingkreis (14) und der Basisschwingkreis (17) werden auf eine gegenüber der Resonanzfrequenz des Kollektorschwingkreises (5) und des Basisschwingkreises (11) unterschiedliche Resonanzfrequenz abgestimmt.

Aufgrund der Erläuterungen zu den Figuren 1 bis 4 ist nunmehr auch das in Figur 5 dargestellte vollständige Schaltungsprinzip verständlich. Über den als Basis-Basis-Stufe ausgebildeten ersten Transistors (2) wird die erste elektrische Schwingung angefacht und über den zweiten Transistor (9) als Emitterfolger zurückgekoppelt. Gleichzeitig wird über den zweiten Transistor (9) in entgegengesetzter Signalflußrichtung die zweite Schwingung angefacht und über den ersten Transistor (2) als Emitterfolger zurückgekoppelt. Die Kollektorschwingkreise (5,14) und die Basisschwingkreise (11,17) sind dabei jeweils so dimensioniert, daß der Schwingquarz (1) auf zwei unterschiedlichen Resonanzfrequenzen angeregt wird.

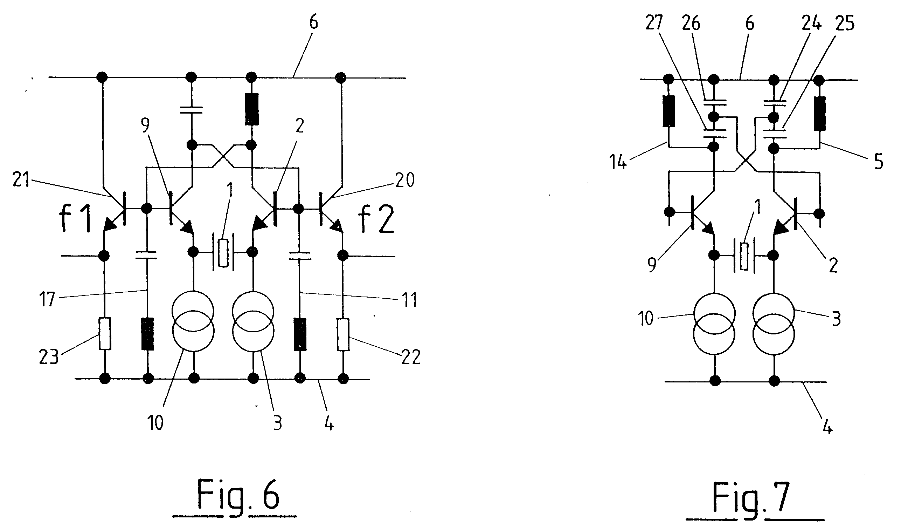

Zur Ermöglichung einer einfachen Auskoppelbarkeit der erzeugten elektrischen Schwingungen ist es gemäß der Ausführungsform in Figur 6 vorgesehen, die Basen der Transistoren (2,9) jeweils an Basen von Ausgangstransistoren (20,21) anzuschließen, die mit ihren Kollektoren an das obere Bezugspotential (6) angeschlossen und mit ihren Emittern über Widerstände (22,23) mit dem unteren Bezugspotential (4) verbunden sind. Die Auskopplung erfolgt dabei jeweils im Bereich der Emitteranschlüsse der Ausgangstransistoren (20,21). Aufgrund der Verwendung der Ausgangstransistoren (20,21) ist es möglich, jeweils einen Kondensator bzw. eine Induktivität der Kollektorschwingkreise (5,14) entfallen zu lassen, da durch die Ausgangstransistoren (20,21) eine Parallelschaltung der wirksamen Impedanz der seriellen Verschaltung der Basisschwingkreise (11,17) erfolgt.

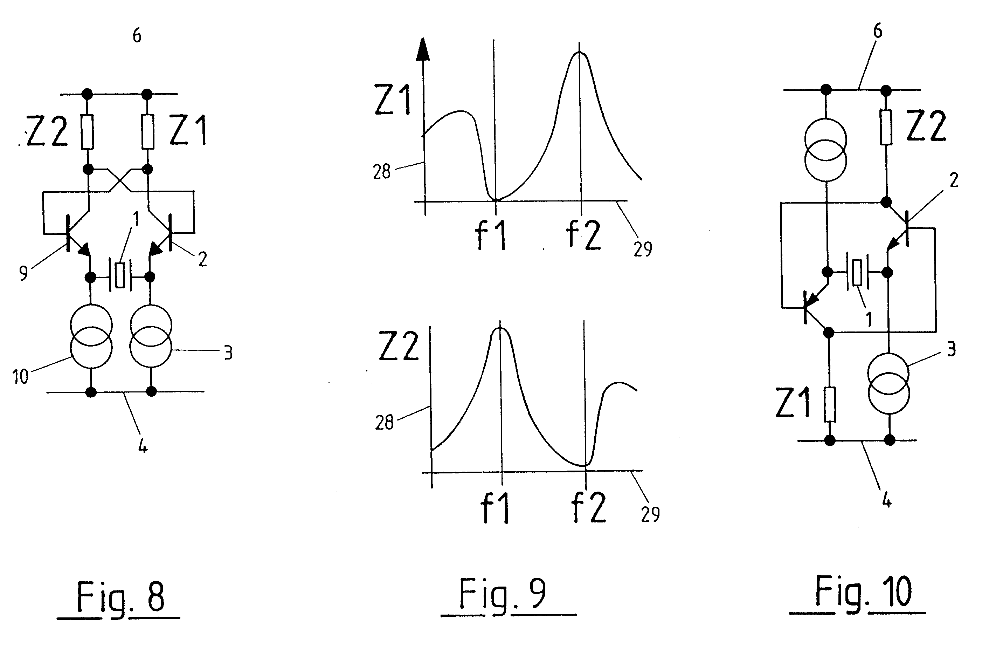

Bei der Ausführungsform gemäß Figur 7 sind die Kondensatoren (7,15) der Kollektorschwingkreise (5,14) jeweils durch eine Reihenschaltung von zwei Kondensatoren (24,25; 26,27) ersetzt. Die Basis des ersten Transistors (2) ist an die Verbindungsstelle der Kondensatoren (26,27) und die Basis des zweiten Transistors (9) an die Verbindung der Kondensatoren (24,25) angeschlossen. Hierdurch ist es möglich, die rückgekoppelten Signale gleichspannungsfrei abzunehmen.

Eine wesentliche Vereinfachung des Schaltbildes erfolgt durch die Zusammenfassung der Bauelemente bei der teilweisen Darstellung gemäß Figur 8. Es ist hierbei der Kollektorschwingkreis (5) zu einer Impedanz Z1 zusammengefaßt und der Kollektorschwingkreis (14) ist durch eine Impedanz Z2 dargestellt.

Die Übertragungsfunktionen zu den Impedanzen Z1 und Z2 sind in Figur 9 veranschaulicht. Die Übertragungsfunktionen sind dabei jeweils in einem Koordinatenkreuz dargestellt, das aus einer Amplitudenachse (28) und einer Frequenzachse (29) ausgebildet ist. Die Übertragungsfunktion der Impedanz Z1 weist bei einer Frequenz f1 eine Nullstelle und bei einer Frequenz f2 eine Polstelle auf. Die Übertragungsfunktion der Impedanz Z2 weist hingegen bei f1 eine Polstelle und bei f2 eine Nullstelle auf. Die Frequenzen f1 und f2 sind entsprechend den Resonanzfrequenzen des Schwingquarzes (1) gewählt.

Die Übertragungsfunktionen gemäß der Darstellung in Figur 9 sind auch den Impedanzen der Basisschwingkreise (11,17) zugeordnet. Dies ist in der vereinfachten teilweisen Darstellung in Figur 10 skizziert.

## Patentansprüche

1. Vorrichtung zur gleichzeitigen Erzeugung von zwei elektrischen Schwingungen mit unterschiedlichen Frequenzen, die einen Schwingquarz mit mindestens zwei unterschiedlichen Resonanzfrequenzen aufweist, dadurch gekennzeichnet, daß ein Emitter eines ersten Transistors (2) über den Schwingquarz (1) mit einem Emitter eines zweiten Transistors (9) verbunden ist, die Basen der Transistoren (2,9) über Basisschwingkreise (11,17) mit einem unteren Bezugspotential (4) und die Kollektoren der Transistoren (2,9) jeweils über Kollektorschwingkreise (5,14) mit einem oberen Bezugspotential (6) verbunden sind, die Basis jeweils eines der Transistoren (2,9) elektrisch mit dem Kollektor jeweils des anderen Transistors (2,9) verbunden ist und die Basen der Transistoren (2,9) jeweils über Wechselstromkoppler (3,10) an das untere Bezugspotential (4) angeschlossen sind.

2. Vorrichtung nach Anspruch 1, dadurch gekennzeichnet, daß eine Übertragungsfunktion des einen Kollektorschwingkreises (5) eine Nullstelle für die erste zu erzeugende Frequenz und eine Übertragungsfunktion des anderen Kollektorschwingkreises (14) eine Nullstelle für die zweite zu erzeugende Frequenz aufweist.

3. Vorrichtung nach Anspruch 1 oder 2, dadurch gekennzeichnet, daß eine Übertragungsfunktion des einen Kollektorschwingkreises (5) eine Polstelle für die zweite zu erzeugende Frequenz und eine Übertragungsfunktion des anderen Kollektorschwingkreises (14) eine Polstelle für die erste zu erzeugende Frequenz aufweist.

4. Vorrichtung nach einem der Ansprüche 1 bis 3, dadurch gekennzeichnet, daß der eine Kollektorschwingkreis (5) aus einer Parallelschaltung eines Kondensators (7) und einer Induktivität (8) und der andere Kollektorschwingkreis (14) gleichfalls aus einer Parallelschaltung eines Kondensators (15) und einer Induktivität (16) ausgebildet ist.

5. Vorrichtung nach einem Ansprüche 1 bis 4, dadurch gekennzeichnet, daß sowohl der eine Basisschwingkreis (11) aus einer Reihenschaltung eines Kondensators (11) und einer Induktivität (13) als auch der andere Basisschwingkreis (17) aus einer Reihenschaltung eines Kondensators (18) und einer Induktivität (19) ausgebildet ist.

6. Vorrichtung nach einem der Ansprüche 1 bis 5, dadurch gekennzeichnet, daß jeweils der eine Kollektorschwingkreis (5) und der zugeordnete Basisschwingkreis (11), bzw. der andere Kollektorschwingkreis (14) und der zugeordnete Basisschwingkreis (17), jeweils gleiche Resonanzfrequenzen aufweisen.

7. Vorrichtung nach einem der Ansprüche 1 bis 6, dadurch gekennzeichnet, daß die Basis mindestens eines der Transistoren (2,9) mit der Basis eines Ausgangstransistors (20,21) verbunden ist, dessen Kollektor an das obere Bezugspotential (6) und dessen Emitter über einen Widerstand (22,23) an das untere Bezugspotential (4) angeschlossen ist.

8. Vorrichtung nach einem der Ansprüche 1 bis 7, dadurch gekennzeichnet, daß mindestens einer der Kondensatoren (7,15) aus einer Reihenschaltung von Kondensatoren (24,25; 26,27) ausgebildet ist und die Basis des jeweils zugeordneten Transistors (2,9) mit dem Mittelabgriff der Kondensatoren (24,25; 26,27) verbunden ist.

9. Vorrichtung nach einem der Ansprüche 1 bis 8, dadurch gekennzeichnet, daß der Schwingquarz (1) als ein Temperaturfühler zur Durchführung eines Frequenzabgleiches einer ihn beinhaltenden Oszillatorschaltung ausgebildet ist.

## Claims

1. Apparatus for simultaneously generating two electrical oscillations having different frequencies and which comprises a quartz resonator having at least two different resonance frequencies, characterized in that an emitter of a first transistor (2) is connected by means of the quartz resonator (1) to an emitter of a second transistor (9), the bases of the transistors (2, 9) are connected by means of base oscillation circuits (11, 17) to a lower reference potential (4) and the collectors of the transistors (2, 9) are in each case connected by means of collector oscillation circuits (5, 14) to a higher reference potential (6), the base of one of the transistors (2, 9) in each case is electrically connected to the collector of the other transistor (2, 9) in each case and the bases of the transistors (2, 9) are connected in each case by means of alternating current couplers (3, 10) to the lower reference potential (4).

2. Apparatus according to Claim 1, characterized in that a transfer function of the one collector oscillation circuit (5) comprises a zero point for the first frequency to be generated and a transfer function of the other collector oscillation circuit (14) comprises a zero point for the second frequency to be generated.

3. Apparatus according to Claim 1 or 2, characterized in that a transfer function of the one collector oscillation circuit (5) comprises a pole point for the second frequency to be generated and a transfer function of the other collector oscillation circuit (14) comprises a pole point for the first frequency to be generated.

4. Apparatus according to any one of Claims 1 to 3, characterized in that the one collector oscillation circuit (5) is formed of a parallel connection of a capacitor (7) and an inductor (8) and the other collector oscillation circuit (14) is likewise formed of a parallel connection of a capacitor (15) and an inductor (16).

5. Apparatus according to any one of Claims 1 to 4, characterized in that both the one base oscillation circuit (11) is formed of a series connection of a capacitor (11) and an inductor (13) and the other base oscillation circuit (17) is formed of a series connection of a capacitor (18) and an inductor (19).

6. Apparatus according to any one of Claims 1 to 5, characterized in that in each case the one collector oscillation circuit (5) and the associated base oscillation circuit (11) or the other collector oscillation circuit (14) and the associated base oscillation circuit (17) respectively comprise identical resonance frequencies in each case.

7. Apparatus according to any one of Claims 1 to 6, characterized in that the base of at least one of the transistors (2, 9) is connected to the base of an output transistor (20, 21) whose collector is connected to the higher reference potential (6) and whose emitter is connected by means of a resistor (22, 23) to the lower reference potential (4).

8. Apparatus according to any one of Claims 1 to 7, characterized in that at least one of the capacitors (7, 15) is formed of a series connection of capacitors (24, 25; 26, 27) and the base of the transistor (2, 9) associated in each case is connected to the centre tap of the capacitors (24, 25; 26, 27).

9. Apparatus according to any one of Claims 1 to 8, characterized in that the quartz resonator (1) is in the form of a temperature sensor for performing a frequency adjustment of an oscillator circuit containing said sensor.

## Revendications

1. Circuit oscillant pour la génération d'au moins deux fréquences différentes, équipé d'un quartz qui possède au moins deux fréquences de résonance, caractérisé en ce que l'émetteur d'un premier transistor (2) est raccordé à l'émetteur d'un deuxième transistor (9) par l'intermédiaire du quartz (1), les bases des transistors (2,9) étant reliées à un potentiel de référence bas (4) via des circuits oscillants dans les bases (11,17) et en ce que les collecteurs des transistors (2,9) sont reliés chacun à un potentiel de référence haut (6) via des circuits oscillants dans les collecteurs (5,14), la base d'un des transistors (2,9) étant connectée électriquement au collecteur de l'autre transistor (2,9) et la base de chacun des transistors (2,9) étant reliée au potentiel de référence bas (4) via un circuit de couplage pour courant alternatif (3,10).

2. Dispositif selon la revendication 1, caractérisé en ce qu'une fonction de transfert d'un premier circuit oscillant de collecteur (5) accuse un passage par zéro pour la première fréquence générée et qu'une fonction de transfert d'un second circuit oscillant de collecteur (14) accuse un passage par zéro pour la deuxième fréquence générée.

3. Dispositif selon les revendications 1 ou 2, caractérisé par le fait qu'une fonction de transfert d'un premier circuit oscillant de collecteur (5) accuse un sommet pour la deuxième fréquence générée et qu'une fonction de transfert d'un second circuit oscillant de collecteur (14) accuse un sommet pour la première fréquence générée.

4. Dispositif selon une des revendications 1 à 3, caractérisé en ce que le premier circuit oscillant de collecteur (5) est constitué d'un branchement en parallèle d'un condensateur (7) et d'une self (8) et que l'autre circuit oscillant de collecteur (14) est également constitué d'un branchement en parallèle d'un condensateur (15) et d'une self (16).

5. Dispositif selon une des revendications 1 à 4, caractérisé en ce que le circuit oscillant dans la base (11) est constitué d'un branchement en série d'un condensateur (11) et d'une self (13), tout comme le circuit oscillant dans la base (17) est constitué d'un branchement en série d'un condensateur (18) et d'une self (19).

6. Dispositif selon une des revendications 1 à 5, caractérisé en ce que le premier circuit oscillant de collecteur (5) et le circuit oscillant dans la base (11) correspondant et l'autre circuit oscillant de collecteur (14) et le circuit oscillant dans la base (17) correspondant ont des fréquences de résonance identiques.

7. Dispositif selon une des revendications 1 à 6, caractérisé en ce que la base d'au moins d'un des transistors (2,9) est raccordée à la base d'un transistor de sortie (20,21) dont le collecteur est raccordé au potentiel de référence haut (6) et dont l'émetteur est relié au potentiel de référence bas à travers une résistance (22,23).

8. Dispositif selon une des revendications 1 à 7, caractérisé en ce qu'au moins un des condensateurs (7,15) est constitué du branchement en série de condensateurs (24,25 ; 26,27) et que la base du transistor correspondant est reliée au point commun des condensateurs (24,25 ; 26,27).

9. Dispositif selon une des revendications 1 à 8, caractérisé en ce que le quartz (1) fait office de capteur de température pour le réglage de la fréquence d'un circuit oscillateur dont il fait partie.
